# EUROPEAN PATENT APPLICATION

(11) **EP 1 630 875 A2**
(43) Date of publication of application: **01.03.2006**
(21) Application number: 05254710.6
(22) Date of filing: 28.07.2005
(51) Int. Cl.: H01L 31/052, H01L 31/02

(54) **Photovoltaic laminate backplane with optical concentrator**

(30) Priority: 24.08.2004 US 711108
(71) Applicant: General Electric Company (a New York Corporation), Schenectady, New York (US)
(72) Inventor: Korman, Charles Steven, New York 12309 (US)
(74) Representative: Pedder, James Cuthbert

(57) **Abstract**

A photovoltaic (PV) laminate backplane assembly (20) includes an insulative substrate (40) and a metal foil (42) bonded to the insulative substrate (40) on a first surface and is electrically receptive for mounting a solar cell (22) on a second surface opposite the first surface. The metal foil (42) includes a light concentrator disposed at exposed regions (54) on the second surface of the metal foil (42) and is configured to reflect incident light thereon to the solar cell (22) to increase a concentration of light on the solar cell (22) in a range of about 1.5X to about 4X.

## Description

Providing electricity through photovoltaic (PV) cells is becoming more popular as this technology has decreased in cost and reliance on other sources of electric power is increasingly disfavored for environmental and strategic reasons. However, providing a cost effective PV module has been elusive since the cost of the PV module is dominated by the cost of the PV cells.

Photovoltaics refer to cells that convert sunlight directly into electrical energy. The electricity produced is direct current that can be used as direct current, converted to alternating current through the use of an inverter, or stored for later use in a battery. Conceptually, in its simplest form, a photovoltaic device is a solar-powered battery whose only consumable is light. Because sunlight is universally available, photovoltaic devices have many advantages over traditional power sources. Photovoltaic systems are distributed power systems such that their electrical power output can be engineered for virtually any application. Moreover, incremental power additions are easily accommodated in photovoltaic systems, unlike more conventional approaches such as fossil or nuclear fuel, which require multi-megawatt plants to be economically feasible.

Although photovoltaic cells come in a variety of forms, the most common structure is a semiconductor material into which a large-area diode, or p-n junction, has been formed. In terms of basic function, electrical current is taken from the device through a contact structure typically on the front that allows the sunlight to enter the solar cell and a contact on the back that completes the circuit.

Up to about eighty percent of the cost of a PV module is dominated by the cost of the PV cells. Reducing the cost of the PV cells is an option to make a PV module economically viable. The most direct path to reducing module cost is to reduce a footprint or amount of silicon used in a PV module, without decreasing a power density of the PV module.

Increasing the efficiency of the PV cell also effectively reduces a cost/Watt, but not a 25% or greater cost reduction needed to make use of a PV cell economically viable. In laboratory tests under controlled conditions, the use of low-level light concentration (i.e., < 3X) has been shown to reduce a silicon footprint by as much as 40% while reducing efficiency by only about 20%. The idea of using concentrated sunlight within a module is not new and several companies have pursued this path. The downside of light concentration is the added cost of such implementation that has reduced the effective cost benefit of reducing a silicon footprint. In addition, the remaining solar cell footprint operates at higher temperatures further reducing the benefit because of efficiency losses.

In an exemplary embodiment of the invention, a photovoltaic (PV) laminate backplane assembly includes an insulative substrate and a metal foil bonded to the insulative substrate on a first surface and is electrically receptive for mounting a solar cell on a second surface opposite the first surface. The metal foil includes a light concentrator disposed at exposed regions on the second surface of the metal foil and is configured to reflect incident light thereon to the solar cell to increase a concentration of light on the solar cell in a range of about 1.5X to about 4X.

In another exemplary embodiment of the invention, a solar cell laminate assembly includes a plurality of solar cells each having a first side and a second side, each of the plurality of solar cells is configured to produce an electrical current when receiving photons on at least the first side and an encapsulant is operably coupled to the first side of each of the plurality of solar cells. An insulative substrate is operably coupled to the second side of each of the plurality of solar cells. A metal foil is bonded to the insulative substrate on a first surface and is electrically receptive for mounting a solar cell on a second surface opposite the first surface. The metal foil includes a light concentrator disposed at exposed regions on the second surface of the metal foil. The light concentrator is configured to reflect incident light thereon to each solar cell to increase a concentration of light on each solar cell in a range of about 1.5X to about 4X.

The invention will now be described in greater detail, by way of example, with reference to the drawings, in which:-
Figure 1 illustrates a current PV module manufacturing process;
Figure 2 illustrates a cross section view of two solar cell module assemblies operably coupled to one another in accordance with an exemplary embodiment;
Figure 3 is a top plan view of a metal foil of Figure 1 detailing an electrical interconnection pattern between the solar cells and an electrical bus disposed on an edge of the assembly in accordance with an exemplary embodiment;
Figure 4 is a bottom perspective view of a silicon wafer of Figure 2 removed illustrating electrical contacts disposed on a bottom surface thereof for connection with the corresponding contacts of the interconnection pattern in accordance with an exemplary embodiment; and
Figure 5 is a cross section view of a solar cell laminate assembly having an optical concentrator disposed on a flexible polymer substrate to reflect incident light thereon to contiguous solar cells in accordance with another exemplary embodiment.

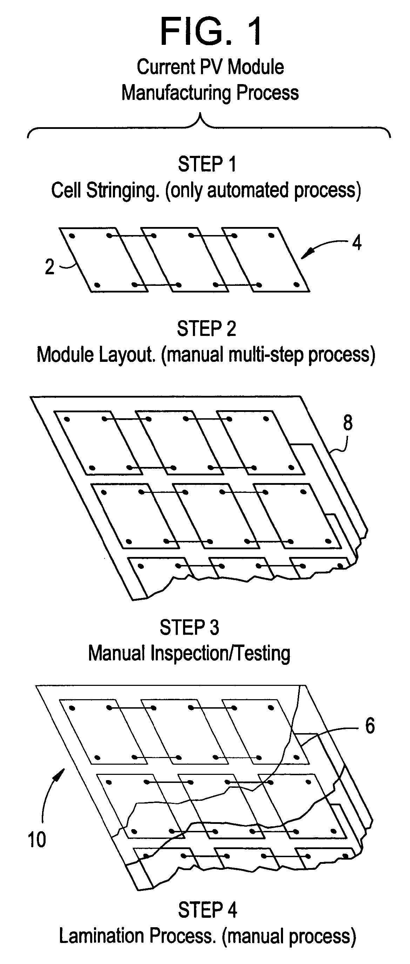

Referring to Figure 1, a conventional procedure for fabrication of a photovoltaic module is illustrated. The procedure varies very little across the PV industry and has remained fundamentally the same for the past 15-20 years. Individual solar cells 2 (independent of the technology) are electrically interconnected into a series string 4 using a tabbing structure at step 1. Solder tabs (not shown) are applied to the individual cells 2 manually or using an automated tabbing machine or stringing machine. The string 4 is the building block of a PV laminate. The stringing process at step 1 involves physical handling of cells 2 which often results in cell breakage requiring manual repair. The strings are typically manually moved to a layup station where multiple strings are arranged onto a top glass 6 (see step 4) that is covered with a plastic sheet (not shown) that will serve as an encapsulating layer at step 2. This is usually a manual operation although some vendors have automated this portion of the layup process. Interconnection of strings 4 is a manual operation requiring the use of tape for electrical isolation and additional copper tabbing which is soldered in place. A polymer back sheet 8 is applied prior to step 4 lamination of the assembly. The laminate can be tested to verify the connections at step 3. Some vendors add special testing to identify damaged cells at step 3. It should be noted that repair is still possible at step 3. The assembly is then sealed using a vacuum lamination process at step 4 forming a conventional PV laminate 10. A number of bottlenecks exist that limit the throughput of the above described process and add cost. Certainly the manual layup of strings and the need to repair damaged strings limit throughput and add cost. The final lamination step also limits throughput.

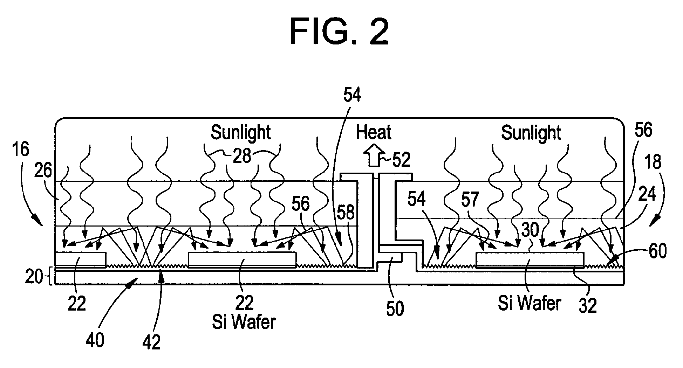

Referring now to Figure 2, two solar cell laminate assemblies 16 and 18 are operably coupled to one another, each being fabricated without stringing any individual cells together in accordance with an exemplary embodiment. Each solar cell laminate assembly 16 and 18 includes a backplane assembly 20 having a plurality of solar cell assemblies or silicon wafers 22 mounted thereto and encapsulated with an encapsulant 24. A glass substrate 26 is disposed over the encapsulant 24 to allow sunlight therethrough indicated generally with rays of photons 28. When an exposed surface or a first side 30 of each silicon wafer 22 receives photons 28 through the glass/encapsulant interface, silicon wafer 22 produces an electrical current on a second opposite side 32, as is well known in the art.

The plurality of solar cells 22 are electrically coupled together via backplane assembly 20. The number of solar cell assemblies is not intended to be limited, the number and configuration of which will depend on the intended application. For exemplary purposes, solar cell assemblies 22 are illustrated. The design of the various solar cell assemblies are substantially the same and electrically coupled to one another in a similar manner.

Still referring to Figure 2, backplane assembly 20 includes an insulating substrate 40 with a metal foil layer 42 intermediate silicon wafers 22 and substrate 40 in an exemplary embodiment. Insulating substrate 40 is a polymeric substrate including a flexible or a rigid polymer. Substrate 40 as shown is a rigid plastic, molded as a plastic module frame about each assembly 16 and 18.

Metal foil 42 includes copper or aluminum, or another metal selected on a combined basis of cost, electrical, and thermal performance. Metal foil 42 is patterned to match an interconnection configuration between silicon wafers 22 and contiguous module laminate assemblies 16, 18. A number of techniques can be used to form the interconnection pattern on metal foil 42 including, but not limited to, mechanical stamping and electro-etching, for example. A thickness of the metal foil is chosen on a basis of the largest current to be carried therethrough. It is envisioned that foil 42 includes a thickness of about 0.5 mils to about 5 mils. The aforementioned dimensions are merely provided as examples and are not intended to limit the scope of the present invention.

Metal foil 42 is bonded to insulating substrate 40. The solar cells or silicon wafers 22 are disposed on the metal foil 42 using a conductive epoxy or a solder (not shown). The foil 42 provides a very low resistance interconnection between cells 22. In addition, foil 42 is effective as a thermal sink for heat generated by the cells 22 in conversion of the solar energy to electrical energy or the heat from the absorbed solar radiation in the laminate assembly 16, 18.

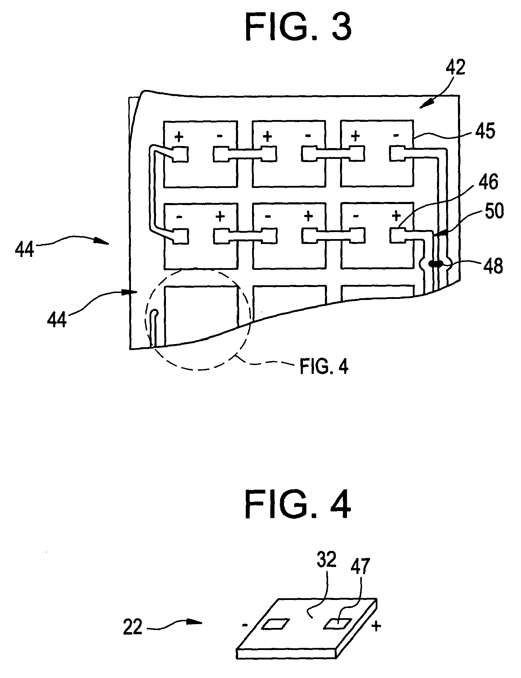

Referring now to Figure 3, metal foil 42 is patterned to segment the electrical interconnection of cells 22 such that the cells 22 can be grouped in a number of ways to provide a suitable current and voltage. Figure 2 shows a number of cells 22 connected in series and a number of wafer locations 45 illustrating an interconnect pattern 46 in such a series string 44. Each series string 44 may include a diode 48 that allows a failed string 44 to be bypassed.

Figure 4 illustrates a backside or second side 32 of a wafer 22 in a series string 44 of Figure 2. As shown in Figures 3 and 4, the current from the segments is transported from corresponding pads 47 on a second side 32 of each cell 22 in a series string 44 and combined at an edge connector 50 of the metal foil 42 corresponding to an edge of the laminate. Figure 3 also illustrates how diodes 48 that may be used to bypass failed segments are mounted to foil 42.

As is well known in the art, when all cells 22 in an array are illuminated, each cell will be forward biased and a forward current will flow. However, if one or more of the cells is shadowed (i.e., not illuminated), by an obstruction or the like, the shadowed cell or cells may become reversed biased because of the voltage generated by the unshadowed cells. Reverse biasing of a cell can cause permanent degradation in cell performance or even complete cell failure. To guard against such damage, it is customary to provide protective bypass diodes. One bypass diode 48 may be connected across several cells, or for enhanced reliability, each cell 22 may have its own bypass diode 48.

Referring again to Figure 2, the heat generated by the photo-electro conversion of cells 22 or by absorbed solar radiation internal to the laminate assemblies 16, 18, is also channeled to the edge connector 50 of the laminate where it can be dissipated by radiation or convection generally indicated at 52 in Figure 2.

Figure 2 illustrates one possible embodiment where contiguous edge connectors 50 from respective laminate assemblies 16 and 18 are operably connected to one another to provide electrical interconnection therebetween, as well as providing a heat sink at respective edges defining each assembly 16, 18. It is contemplated that edge connectors 50 may be operably connected via corresponding snap-fit features (not shown).

Metal foil 42 also serves as an integral element of a low level solar concentrator. In regions 54 where solar cells 22 are not mounted on foil 42, light entering the laminate assemblies 16 and 18 will be reflected to a contiguous solar cell 22. In this manner, regions 54 function as a reflector 54 of light. In an exemplary embodiment, the angle of reflection of light on regions 54 is controlled so that when the reflected light strikes a top interface 56 of the laminate or a bottom surface of glass substrate 26, the reflected light is returned to the surface 30 of the remaining solar cells 22 resulting in a concentration or enhancement of light intensity generally shown at 57 in Figure 1. The light enhancement on surface 30 of each cell 22 increases to a range from about 1.5 times (1.5X) to about 4 times (4X) depending upon the arrangement of the solar cells 22 and design of the reflector.

A number of techniques can be used to modify and/or control the nature of light reflection from a surface 58 of metal foil 42 corresponding to regions 54. The surface 58 can be patterned using etching or mechanical replication methods. For example, surface 58 of foil 42 is patterned as a saw tooth pattern generally indicated at 60 in Figure 1. The saw tooth pattern 60 includes angular sides defining each saw tooth to reflect light to interface 56 for further reflection onto surface 30 of cells 22. Reflection from metal foil 42 can be further enhanced by disposing a reflective coating 66 (see Figure 4) on surface 58. It is also contemplated that a surface of glass substrate 26 corresponding with interface 56 may be etched or patterned to ensure reflection onto surface 30 to trap as much light as possible, as opposed to escaping through the glass. In this manner, total internal reflection is optimized by optimizing the light scattering at interface 56. The patterned glass 26 at interface 56 will also improve adhesion with plastic encapsulant 24.

Furthermore, it is envisioned, for example, that surface 58 of foil 42 may be etched to include line gratings to increase reflected light onto surface 30 or may include various geometric pitches including interface 56 of glass 26 to obtain the desired reflection back onto surface 30 of each cell 22. It will be recognized by one skilled in the pertinent art that random pitches are also contemplated in addition to the uniform saw tooth pitch illustrated in Figure 1.

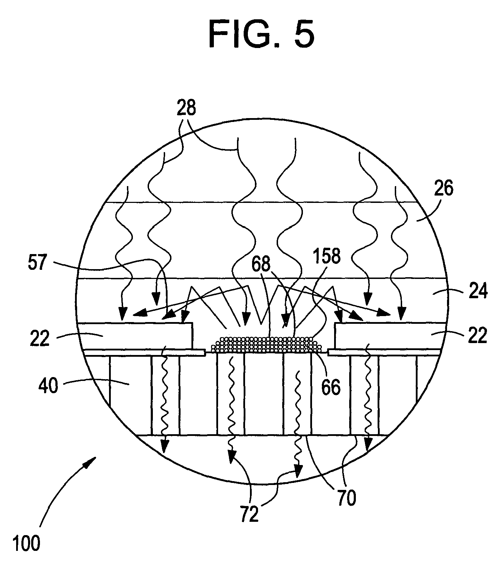

Figure 5 illustrates an alternative embodiment of a laminate assembly 100 that includes coating 66 disposed directly on metal foil 42. For instance, coating 66 may be an "ink" 66 that can be made reflective by printing a reflective "ink" on the metal foil 42. Figure 5 shows an example of ink 66 that is a colloidal suspension of very small glass spheres 68 in an optically transparent binder. When this ink 66 (e.g., small glass spheres 68) is printed onto metal foil 42, the result modifies how light is reflected from the surface 158. If the ink 66 is properly designed (e.g., proper size and distribution of spheres 68), then the light will be reflected at some angular distribution relative to the incident light indicated with photons 28.

Still referring to Figure 5, flexible substrate 40 can be constructed from a thermally non-conductive polyimide identified by the trademark "KAPTON H" or the trademark "KAPTON E", manufactured by DuPont Corporation. Because the KAPTON® product is a thermally non-conductive polyimide, the inventors herein have recognized that the heat radiating layers can be disposed through the KAPTON® layer 40 to radiate excess heat generated in solar cell 22, and the other solar cells in the solar cell array from a backside of solar cell array. However, it will be recognized that other suitable materials may be employed suitable to the desired end purpose. In another exemplary embodiment illustrated in Figure 5, flexible substrate 40 may include metallized apertures 70 therethrough to allow excess heat generated in solar cell 22, and the other solar cells in the solar cell array, to radiate from a backside of the solar cell array generally indicated at 72. More specifically, apertures 70 may be copper filled in thermal communication with metal foil 42 which is in turn in thermal communication with each cell 22.

The solar cell assemblies and a method for controlling a temperature of the solar cell assemblies described herein represent a substantial advantage over known solar cell assemblies and methods. In particular, the solar cell assemblies are configured to radiate excess heat energy from the solar cell assemblies from the backside of the assemblies to the edge of the assemblies using a single metal foil layer. Accordingly, an operating temperature of the solar cell assembly can be maintained within an optimal operating temperature range thus avoiding efficiency losses due to operation at higher temperatures.

In alternate embodiments, substrate 40 can be constructed from films of one or more of the following materials: (i) polyethyleneterephthalate ("PET"), (ii) polyacrylates, (iii) polycarbonate, (iv) silicone, (v) epoxy resins, (vi) silicone-functionalized epoxy resins, (vii) polyester such as polyester identified by the trademark "MYLAR" manufactured by E.I. du Pont de Nemours & Co., (viii) a material identified by the trademark "APICAL AV" manufactured by Kanegafugi Chemical Industry Company, (ix) a material identified by the trademark "UPILEX" manufactured by UBE Industries, Ltd.; (x) polyethersulfones "PES," manufactured by Sumitomo, and (xi) a polyetherimide identified by the trademark "ULTEM" manufactured by General Electric Company.

The above described disclosure specifies technical approaches that allow a single component of a PV laminate to function as an electrical conductor, thermal conductor, and optical reflector. This differs from other approaches that add new components to the laminate such as an additional material layer that provides the optical reflection. Two specific approaches have been described, one based on a single metal foil 42 that can perform all three functions and an ink 66 that can be used to modify the optical performance of a substrate such as an electrical flex substrate that already supports the bonding and interconnection of solar cells. The particular configurations illustrated in Figures 2-5 are provided as examples and the present invention is not intended to be limited to the specific configurations illustrated in the Figures.

The optical concentrator allows a portion of the silicon to be removed from the module laminate; the area that is left bare will function to redirect light back to the encapsulant/glass interface 56 in a controlled manner so that additional (concentrated) light falls onto the remaining solar cells 22. As a result, the optical concentrator allows a significant reduction in module cost: delta cost = original cost of silicon * % reduction in silicon * (energy factor) * (cost enhancement factor). It will be noted that the energy factor will be less that 1, but should be very close to 1 in an ideal world, while the cost enhancement factor will likely be greater than 1, since it will cost more to make such a module with reduced silicon. In the end, the net cost is reduced because of the cost advantage provided by the % reduction in silicon overrides the increased cost enhancement factor to implement a reduction in a silicon footprint per module combined with the reduced energy factor (e.g., about 0.8 or 80%).

The advantages of using a metal foil layer include a method for concentrating light that allows a solar cell area to be reduced without impacting energy delivery and significantly reducing cost. Another advantage disclosed includes the electrical, thermal, and optical functions to be integrated into a single component (i.e., metal foil), which serves as part of the laminate back sheet, thus greatly reducing implementation cost and simplifying laminate assembly.

The metal foil serves as a substrate for the mounting of solar cells that can be attached to the foil patterned to conform to the metal interconnect/bond pad arrangement of the solar cell design. The metal-to-metal bonding is facilitated by using either an adhesive or a solder. The foil provides excellent current spreading and electrical conductivity with lower sheet resistance than the metallization of a typical solar cell and exceeds the current handling capability of typical tabbing contacts or thin metallization associated with electronic flex substrates. In addition, the metal foil doubles as an excellent spreader of heat generated directly by the solar cell or as a byproduct of absorption of solar radiation internal to the laminate. The design and integration of the foil with the laminate structure allows electrical current and heat to be directed to the edges of the laminate where the electrical current can be channeled externally through an electrical connector integrated with the laminate and the heat can be dissipated through a radiative or convective interface into the external environment. In addition, the surface of the foil can be modified in a number of ways (e.g. using etching, mechanical impression, and the like) and augmented by coatings to reflect light in a particular manner. In this manner, regions of the foil to which solar cells are not bonded are able to reflect light back up to the glass/encapsulant interface of the laminate over a range of angles. The total internal reflection is increased and additional light is reflected back to the solar cells increasing the effective intensity, resulting in a concentration of sunlight in the 1.5-4X range.

## Claims

1. A photovoltaic (PV) laminate backplane assembly (20) comprising:
an insulative substrate (40); and
a metal foil (42) bonded to said insulative substrate (40) on a first surface and electrically receptive for mounting a solar cell (22) on a second surface opposite said first surface, said metal foil (42) including a light concentrator disposed at exposed regions (54) on said second surface of said metal foil (42), said light concentrator configured to reflect incident light thereon to said solar cell (22) to increase a concentration of light on said solar cell (22) in a range of about 1.5X to about 4X.

2. The assembly of claim 1, wherein said substrate (40) comprises a polymeric substrate.

3. The assembly of claim 2, wherein said polymeric substrate comprises one of a flexible and a rigid polymer.

4. The assembly of claim 1, wherein said exposed regions (54) on said second surface of said metal foil (42) disposed proximate edges defining peripheral edges of said solar cell (22) is one of augmented by a coating (66) and mechanically modified to reflect light onto said solar cell (22) and enhance light intensity thereon.

5. The assembly of claim 4, wherein said coating (66) includes a reflective ink.

6. The assembly of claim 5, wherein said ink includes a colloidal suspension of glass spheres (68) in an optically transparent binder.

7. The assembly of claim 1, wherein said metal foil (42) is at least one of copper, aluminum and a conductive metal foil (42) selected on a basis of cost, electrical, and thermal performance.

8. The assembly of claim 7, wherein said metal foil (42) is patterned to match at least an interconnection configuration of said solar cell (22) and a PV laminate module (10).

9. The assembly of claim 8, wherein said metal foil (42) is configured to provide a low resistance interconnection of a plurality of solar cells (22) while providing a thermal sink for heat generated by each cell.

10. The assembly of claim 9, wherein heat generated by at least one of said solar cells (22) and absorbed solar radiation internal to said module is channeled to an edge defining said module via said metal foil (42).
